# EUROPÄISCHE PATENTSCHRIFT

(11) **EP 2 914 688 B1**
(45) Veröffentlichungstag und Bekanntmachung des Hinweises auf die Patenterteilung: **08.05.2019**
(21) Anmeldenummer: 13773619.5
(22) Anmeldetag: 04.10.2013
(51) Int. Cl.: H01L 33/50, F21Y 115/10, F21V 9/30, C09K 11/64, H05B 33/14

(54) **EU-AKTIVIERTE LEUCHTSTOFFE**
EU-ACTIVATED LUMINOPHORES
SUBSTANCES LUMINESCENTES ACTIVÉES PAR EU

(30) Priorität: 02.11.2012 DE 102012021570
(43) Veröffentlichungstag der Anmeldung: 09.09.2015
(73) Patentinhaber: Merck Patent GmbH, 64293 Darmstadt (DE)
(72) Erfinder: PETRY, Ralf, 64347 Griesheim (DE); WINKLER, Holger, 64291 Darmstadt (DE); VOSGROENE, Tim, 64372 Ober-Ramstadt (DE); HAMPEL, Christof, 65936 Frankfurt am Main (DE); BENKER, Andreas, 64686 Lautertal (DE); JUESTEL, Thomas, 58455 Witten (DE)
(86) Internationale Anmeldenummer: PCT/EP2013/002997
(87) Internationale Veröffentlichungsnummer: WO 2014/067609

(56) Entgegenhaltungen:
- EP-A1- 1 811 009
- EP-A1- 1 832 641
- EP-A2- 1 130 075
- FR-A1- 2 205 736
- US-A1- 2006 103 310
- WEI LÜ ET AL: "Spectral tuning and energy transfer in a potential fluorescent lamp phosphor BaMgAlSiO:Eu", JOURNAL OF LUMINESCENCE, ELSEVIER BV NORTH-HOLLAND, NL, Bd. 132, Nr. 9, 16. April 2012 (2012-04-16), Seiten 2439-2442, XP028520345, ISSN: 0022-2313, DOI: 10.1016/J.JLUMIN.2012.04.016 [gefunden am 2012-04-25]
- PAWADE V B ET AL: "Synthesis and optical studies of novel Euand Cedoped BaMgAlSiOphosphors", SOLID STATE SCIENCES, ELSEVIER, PARIS, FR, Bd. 14, Nr. 5, 9. Februar 2012 (2012-02-09), Seiten 607-610, XP028419450, ISSN: 1293-2558, DOI: 10.1016/J.SOLIDSTATESCIENCES.2012.02.004 [gefunden am 2012-02-21]
- KUBOTA S ET AL: "SR3AL10SIO20:EU2+ AS A BLUE LUMINESCENT MATERIAL FOR PLASMA DISPLAYS", APPLIED PHYSICS LETTERS, AMERICAN INSTITUTE OF PHYSICS, 2 HUNTINGTON QUADRANGLE, MELVILLE, NY 11747, Bd. 81, Nr. 15, 7. Oktober 2002 (2002-10-07), Seiten 2749-2751, XP001142150, ISSN: 0003-6951, DOI: 10.1063/1.1512306

## Beschreibung

### Technisches Gebiet

Die Erfindung betrifft Eu²⁺⁻ aktivierte Leuchtstoffe, Verfahren zur Herstellung dieser Verbindungen, sowie Leuchtstoffmischungen, Lichtquellen und Beleuchtungseinheiten, welche die erfindungsgemäßen Eu²⁺⁻ aktivierten Leuchtstoffe enthalten.

### Stand der Technik

Lumineszierende Materialien werden in Fluoreszenzlichtquellen, emissiven Bildschirmen und als Szintillatorkristalle für die Konversion von nicht sichtbarer Strahlung oder Hochenergiepartikeln in sichtbares Licht verwendet. Eine Materialklasse, die weite Verbreitung für diese Aufgabe gefunden hat, sind die Ce³⁺ dotierten Granate, insbesondere Y₃Al₅O₁₂:Ce (YAG) und (Gd₁₋ₓYₓ)₃(At_{1-y}Ga_{y})₅O₁₂:Ce (YAGaG:Ce), wobei weitere Dotierungen, wie Lu³⁺ oder Tb³⁺, zur Optimierung des Spektrums verwendet wurden.

Schon 1996, d.h. kurz nach der technischen Realisierung von blauen InGaN LEDs mit hoher Energieeffizienz und einem Lichtstrom von mehreren Candela, wurden weiße LEDs durch die teilweise Konversion des blauen Lichts mit YAG:Ce bzw. YAGaG:Ce realisiert, da die gelb-orange Emissionsfarbe dieser Leuchtstoffe komplementär zur blauen Emissionsfarbe der LEDs ist und damit additiv weißes Licht erhalten werden kann.

Bis heute enthalten alle kommerziell erhältlichen weißen LEDs einen blau-emittierenden InGaN Chip, der mit einer Schicht aus YAG:Ce oder YAGaG:Ce bedeckt ist. Wesentlicher Nachteil dieses Ansatzes ist einerseits die Abhängigkeit der Emissionsfarbe vom Blickwinkel, was eine Folge der nicht homogenen Beschichtung des Chips ist. Andererseits hängt bei einer Lichtquelle basierend auf einem dichromatischen Spektrum (blau + gelb-orange) die Farbwiedergabe von der Farbtemperatur ab und niedrige Farbtemperaturen (T_{c} < 5000 K) lassen sich nicht mit einer genügend hohen Farbwiedergabe (CRI > 80) realisieren.

Darum ist das gegenwärtig vorrangige Ziel zur Erweiterung des Produktspektrums und zur Verbesserung der Farbwiedergabe weißen LEDs die Realisierung trichromatischer LEDs. Dazu müssen grün- bzw. gelb- und rot-emittierende Leuchtstoffe mit hoher Absorption im blauen Spektralbereich, mit hoher Quantenausbeute und einem hohem Lumenäquivalent bereitgestellt werden. Lü et al. betrifft die spektrale Anpassung und den Energietransfer in Leuchtstoffen der Formel BaMg2Al6Si9030:Eu2+(Journal of Luminescence 132 (2012) 2439-2442).

Pawade et al. beschreibt die Synthese und optische Untersuchung von Eu2+- und Ce3+ dotierten BaMg8Al18Si18O72-Leuchtstoffen (Solid State Sciences 14, (2012) 607-610).

Derzeit sind nur wenige effiziente, schmalbandig grün-emittierende Systeme mit einem Hauptemissionspeak im Wellenlängenbereich zwischen 450 und 580 nm bekannt. Beispiele hierfür sind grün-emittierenden Orthosilikate und Thiogallate
Für viele Anwendungen, z. B. in LCD-Backlights, werden blau- oder im nahen UV anregbare, sehr temperaturstabile Leuchtstoffe mit einem Hauptemissionspeak zwischen 450 und 580 nm benötigt. Diese Wellenlänge passt ideal zu den üblichen Farbfiltern und ermöglicht eine gute Farbwiedergabe. Die gute Temperaturstabilität ist notwendig, da sich der Leuchtstoff bedingt durch hohe Chip-Temperaturen bei hohen Leistungen und bedingt durch im Leuchtstoffkörper entstehende Wärme auf Temperaturen bis 200°C erhitzt.

Ursache des zweiten Erwärmungsmechanismus ist der sogenannte Stokes-Shift, also die Energiedifferenz zwischen absorbiertem und emittiertem Photon, die im Leuchtstoff in Wärme umgesetzt wird.

Bisher gibt es nur wenige bekannte, schmalbandig grün-emittierenden Leuchtstoffe, die auch bei hohen Temperaturen, vorzugsweise mindestens 125°C, insbesondere bei mindestens 175°C, noch hohe Effizienzen aufweisen, und zwar mindestens 80%, insbesondere sogar mindestens 90% der Effizienz bei Raumtemperatur. Mit schmalbandig ist eine FWHM von höchstens 80 nm gemeint. Mit grün-emittierend ist ein Leuchtstoff gemeint, dessen Hauptemissionspeak im Wellenlängenbereich 440 bis 580 nm liegt.

### Darstellung der Erfindung

Überraschenderweise wurde nun gefunden, dass die phasenreinen Verbindungen der Formel I die genannten Anforderungen erfüllen,

(A_{1-w}Eu_{w})(E_{12-2z}(G₁Mg₁)_{z}O₁₉ I

worin
A ein oder mehrere divalente Elemente ausgewählt aus der Gruppe Mg, Sr, Ba und Ca,
E ein oder mehrere trivalente Elemente ausgewählt aus der Gruppe Al, B, Ga, In und Sc, vorzugsweise Al und Ga, besonders bevorzugt AI,
G ein oder mehrere tetravalente Elemente ausgewählt aus der Gruppe Si und Ge, vorzugsweise Si, bedeuten,
0 < z ≤ 4, vorzugsweise z = 1 ist, und
0,01 ≤ w ≤ 0,4, vorzugsweise 0,01 ≤ w ≤ 0,1 ist.

Der neuartige Leuchtstoff zeigt sehr gute thermische und chemische. Stabilität. Er lässt sich sehr gut für beispielsweise Weiße LEDs, Color-On-Demand (COD), TV-Backlighting-LEDs und elektrische Lampen wie Leuchtstofflampen anwenden.

Angegeben wird weiterhin ein Herstellverfahren für den neuartigen Leuchtstoff.

### Kurze Beschreibung der Zeichnungen

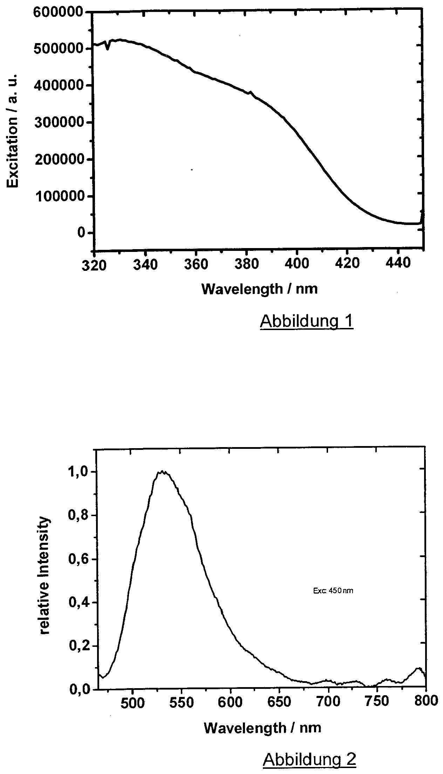

Figur 1 zeigt ein Anregungsspektrum von Sr_{0,96}Eu_{0,04}Al₁₀MgSiO₁₉. Das Spektrum wurde an einer halbunendlich dicken Pulverschicht mit einem Edinburgh Instruments FL900 Spektrometer unter Verwendung einer Xe-Hochdrucklampe und eines Hamamatsu Photomultipliers bei Raumtemperatur aufgenommen.
Figur 2 zeigt das normierte Emissionsspektrum von Sr_{0,96}Eu_{0,04}Al₁₀MgSiO₁₉ bei einer Anregungswellenlänge von 450 nm. Das Spektrum wurde an einer halbunendlich dicken Pulverschicht mit einem Edinburgh Instruments FL900 Spektrometer unter Verwendung einer Xe-Hochdrucklampe und eines Hamamatsu Photomultipliers bei Raumtemperatur aufgenommen.

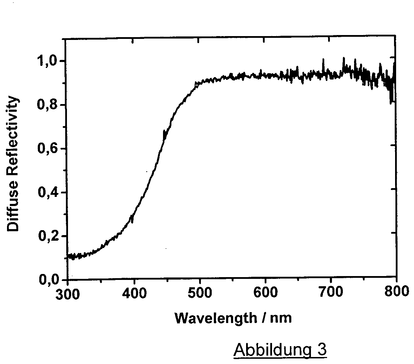

Figur 3 zeigt ein Reflexionsspektrum von Sr_{0,96}Eu_{0,04}Al₁₀MgSiO₁₉ Das Spektrum wurde an einer halbunendlich dicken Pulverschicht mit einem Edinburgh Instruments F920 Spektrometer in einer Ulbricht.-Kugel unter Verwendung einer Xe-Hochdrucklampe und eines Hamamatsu Photomultipliers bei Raumtemperatur aufgenommen.

### Offenbarung der Erfindung

In einer bevorzugten Ausführungsform sind die erfindungsgemäßen Verbindungen der Formel I ausgewählt aus den Verbindungen der Formel II, in denen z gleich 1 ist,

(A_{1-w}Eu_{w})(E₁₀(G₁Mg₁)O₁₉ II

und die Parameter A, E, G und w die in Formel I angegebene Bedeutung haben.

Ferner sind Verbindungen der Formel II bevorzugt ausgewählt aus den Verbindungen der Formel III in denen G gleich Si ist:

(A_{1-w}Eu_{w})(E₁₀SiMg)O₁₉ III

und worin die Parameter A, E und w die in Formel I angegebene Bedeutung haben.

Desweiteren sind Verbindungen der Formeln III, bevorzugt ausgewählt aus den Verbindungen der Formel IV, in denen E gleich Al ist,

(A_{1-w}Eu_{w})(Al₁₀SiMg)O₁₉ IV

worin die Parameter A und w die in Formel I angegebene Bedeutung haben.

Insbesondere sind die Verbindungen der Formel IV, bevorzugt ausgewählt aus den Verbindungen der Formeln V-1 bis V-7,

((SrₛBaᵣCaₜ)_{1-w}Eu_{w})(Al₁₀SiMg)O₁₉ V-1

((CaₜBaᵣ)_{1-w}Eu_{w}) (Al₁₀SiMg)O₁₉ V-2

((SrₛBaᵣ)_{1-w}Eu_{w}) (Al₁₀SiMg)O₁₉ V-3

«SrₛCaₜ)_{1-w}Eu_{w}) (Al₁₀SiMg)O₁₉ V-4

(Sr_{1-w}Eu_{w}) (Al₁₀SiMg)O₁₉ V-5

(Ba_{1-w}Eu_{w}) (Al₁₀SiMg)O₁₉ V-6

(Ca_{1-w}Eu_{w}) (Al₁₀SiMg)O₁₉ V-7

worin 0 < r < 1, 0 < s < 1, 0 < t < 1, mit r + s + t= 1 und w die unter Formel I angegebene Bedeutung hat.

Durch partielle Substitution der divalenten Elemente Sr, Ba oder Ca durch Eu²⁺ im Wirtsgitter ergibt sich überraschenderweise ein sehr effizienter Leuchtstoff. Dabei ist wichtig, dass der Gehalt an divalenten Elementen so eingestellt wird, dass eine zu starke Energiemigration zwischen den Eu²⁺-Ionen verhindert wird. Sehr gut geeignete Leuchtstoffe erhält man für Eu²⁺-Konzentrationen (w) zwischen 0,01 und 0,4, vorzugsweise 0,01 und 0,1.

Typische Arbeitstemperaturen liegen bei LED-Anwendungen im Bereich von 80°C. In diesem Zusammenhang sind Temperaturstabilitäten von mindestens 100°C für LED-Anwendungen wünschenswert. Die erfindungsgemäßen Verbindungen der Formel I zeichnen sich durch eine hohe Temperaturstabilität von mindestens 150°C, vorzugsweise mindestens 200°C aus.

Die erfindungsgemäßen Verbindungen der Formel I zeichnen sich ferner durch ihre hohe chemische Stabilität aus. So sind die Verbindungen der Formel I unempfindlich gegen Oxidation und Hydrolyse.

Ein weiterer Erfindungsgegenstand ist ein Verfahren zur Herstellung der Verbindung der Formel I umfassend folgende Schritte:
1. Mischen einer Magnesiumverbindung, vorzugsweise Magnesiumcarbonat mit,
   a) Silizium- und/oder Germaniumdioxid ,
   b) mindestens einer Aluminium-, Indium-, Scandium- und/oder Galliumverbindung, vorzugsweise ausgewählt aus Aluminium-, Indium-, Scandium- und/oder Galliumcarbonat
   c) mindestens einer Barium-, Strontium- und/oder Calciumverbindung, vorzugsweise ausgewählt aus Barium-, Strontium- und/oder Calciumcarbonat und
   d) mindestens einer Europiumverbindung, vorzugsweise ausgewählt aus Europiumoxid, Europiumcarbonat, Europiumnitrat und/oder Europiumoxalat,
2. Thermische Behandlung der Mischung.

Bei der oben genannten thermischen Behandlung erfolgt die Umsetzung üblicherweise bei einer Temperatur oberhalb 800°C. Vorzugsweise erfolgt die thermische Behandlung in einem Mehrstufenprozess, besonders bevorzugt in einem 2-stufigen Prozess, d.h. zuerst wird bei einer Temperatur > 800°C unter Luft kalziniert und anschließend vorzugsweise bei einer Temperatur > 1000°C, besonders bevorzugt bei einer Temperatur von 1200 bis 1800°C unter reduzierenden Bedingungen (z.B. mit Kohlenmonoxid, Formiergas oder Wasserstoff oder Sauerstoffmangel-Atmosphäre) kalziniert.

In einer weiteren erfindungsgemäßen Ausführungsform können vor der thermischen Behandlung anorganische oder organische Stoffe aus der Gruppe der Ammoniumhalogenide, Erdalkalifluoride wie Calcium-, Strontium- oder Bariumfluorid, (Erd)-Alkalimetallborate, Borsäure, (Erd)Alkalimetallcarbonate oder Ammoniumhydrogencarbonat, Zitronensäure, Alkoholate sowie Oxalate und/oder Kieselsäureester wie z.B. TEOS eingesetzt werden. Bevorzugt wird Zitronensäure und ein Oxalat zugesetzt.

Die Herstellung der erfindungsgemäßen Leuchtstoffe kann entweder über eine herkömmliche Festkörperdiffusionsmethode (ausgehend von den Oxiden, Nitraten, Carbonaten oder Halogeniden der entsprechenden Erdalkalimetalle, Halbmetalle, Metalle oder Seltenerden) oder nasschemisch aus anorganischen und/oder organischen Halbmetall- und/ oder Metall- und/oder Seltenerd-Salzen mittels Sol-Gel-Verfahren, Copräzipitations- und /oder Trocknungsverfahren erfolgen.

Bei den nasschemischen Verfahren über wässrige Vorstufen (Precursoren) der Leuchtstoffe sind folgende Methoden bekannt:
- Cofällung (auch Copräzipitation genannt) mit einer NH₄HCO₃-Lösung *(siehe z.B.* Jander, Blasius Lehrbuch der analyt. u. präp. anorg. Chem. 2002*)*
- Pecchini-Verfahren mit einer Lösung aus Zitronensäure und Ethylenglykol (*siehe z.B.* Annual Review of Materials Research Vol. 36: 2006, 281-331*)*
- Combustion-Verfahren unter Verwendung von Harnstoff
- Sprühtrocknung wässriger oder organischer Salzlösungen (Edukte)
- Sprühpyrolyse (auch Spraypyrolyse genannt) wässriger oder organischer Salzlösungen (Edukte)
- Eindampfen von Nitratlösungen und thermischer Umsetzung des Rückstandes
- Fällung mit einer Lösung, die Zitronensäue oder Oxalat enthält

Bei der o.g. Cofällung werden z.B. Chloridlösungen der entsprechenden Leuchtstoffedukte mit einer TEOS/NH₄HCO₃-Lösung versetzt, wodurch sich der Leuchtstoffprecursor bildet, der anschließend durch eine ein- oder mehrstufige thermische Behandlung in den Leuchtstoff umgewandelt wird. Beim Pecchini-Verfahren werden z.B. Nitratlösungen der entsprechenden Leuchtstoffedukte bei Raumtemperatur mit einem Fällungsreagenz bestehend aus Zitronensäure und Ethylenglykol versetzt und anschließend erhitzt. Durch Erhöhung der Viskosität kommt es zur Leuchtstoffprecursor-Bildung.

Beim Combustion-Verfahren werden z.B. Nitratlösungen der entsprechenden Edukte in Wasser gelöst, dann unter Rückfluss gekocht und mit Harnstoff versetzt, wodurch sich der Leuchtstoffprecursor langsam bildet.

Die Sprühpyrolyse gehört zu den Aerosolverfahren, die durch Versprühen von Lösungen, Suspensionen oder Dispersionen in einen durch unterschiedliche Art und Weise erhitzten Reaktionsraum (Reaktor) sowie die Bildung und Abscheidung von Feststoff- Partikeln gekennzeichnet sind. Im Gegensatz zur Sprühtrocknung mit Heißgastemperaturen < 200°C finden bei der Sprühpyrolyse als Hochtemperatur-Prozess außer der Verdampfung des Lösungsmittels zusätzlich die thermische Zersetzung der verwendeten Edukte (z. B. Salze) sowie die Neubildung von Stoffen (z. B. Oxide, Mischoxide) statt.

Bei der Fällung mit einer Lösung aus Zitronensäure oder Oxalat werden z.B. Oxide oder Carbonatlösungen der entsprechenden Edukte in konz. HNO₃ gelöst und anschließend mit der o.g. Lösung versetzt, bevor dann eingedampft oder filtriert wird. Diese Methode ist erfindungsgemäß bevorzugt.

Die ersten sechs der o.g. Verfahrensvarianten sind ausführlich in der WO2007/144060 (Merck) beschrieben, die voll umfänglich in den Kontext der vorliegenden Anmeldung durch Bezugnahme eingefügt wird.

Verbindungen der Formel I zeichnen sich insbesondere dadurch aus, dass sie durch Strahlung im Wellenlängenbereich von 300 nm bis 450 nm angeregt werden können und dabei sichtbares Licht im Wellenlängenbereich von 440 nm bis 580 nm emittieren.

Im Kontext dieser Anmeldung wird als UV-Licht solches Licht bezeichnet dessen Emissionsmaximum zwischen 300 und 399 nm liegt, blaues Licht solches Licht bezeichnet, dessen Emissionsmaximum zwischen 400 und 459 nm liegt, als cyan-farbenes Licht solches, dessen Emissionsmaximum zwischen 460 und 505 nm liegt, als grünes Licht solches, dessen Emissionsmaximum zwischen 506 und 545 nm liegt, als gelbes Licht solches, dessen Emissionsmaximum zwischen 546 und 565 nm liegt, als orange Licht solches, dessen Emissionsmaximum zwischen 566 und 600 nm liegt und als rotes Licht solches, dessen Emissionsmaximum zwischen 601 und 670 nm liegt. Die erfindungsgemäßen Verbindungen der Formel I sind vorzugsweise grün-emittierende Konversionsleuchtstoffe.

In Abhängigkeit der Zusammensetzung, insbesondere im Hinblick auf die Variation des Parameters A, kann die Emission gezielt variiert werden. So werden insbesondere die Verbindungen der Formel V-1 vorzugsweise durch Strahlung im Wellenlängenbereich von 300 nm bis 450 nm angeregt und emittieren Licht im Wellenlängenbereich von 440 nm bis 580 nm mit einer Halbwertsbreite (FWHM) des Hauptemissionspeaks von maximal 80 nm.

Verbindungen der Formel V-5 werden vorzugsweise durch Strahlung im Wellenlängenbereich von 300 nm bis 450 nm angeregt und emittieren Licht im Wellenlängenbereich von 480 nm bis 550 nm mit einer Halbwertsbreite (FWHM) des Hauptemissionspeaks von maximal 80 nm.

Verbindungen der Formel V-6 werden vorzugsweise durch Strahlung im Wellenlängenbereich von 300 nm bis 450 nm angeregt und emittieren Licht im Wellenlängenbereich von 440 nm bis 500 nm mit einer Halbwertsbreite (FWHM) des Hauptemissionspeaks von maximal 80 nm.

Die volle Breite bei halbem Maximum (Halbwertsbreite oder FWHM) ist ein Parameter, der häufig verwendet wird, um die Breite eines Peaks oder einer Funktion zu beschreiben. Sie wird in einem zweidimensionalem Koordinatensystem (x, y) durch den Abstand (□x) zwischen zwei Punkten auf der Kurve mit gleichem y-Wert definiert, bei dem die Funktion die Hälfte seines maximalen Wert (yₘₐₓ/2) erreicht.

Die Partikelgröße der erfindungsgemäßen Leuchtstoffe ist üblicherweise zwischen 50 µm und 1 µm, vorzugsweise zwischen 30 µm und 3 µm, besonders bevorzugt zwischen 20 µm und 5 µm.

In einer weiteren bevorzugten Ausführungsform besitzen die Leuchtstoffe in Partikelform eine geschlossene Oberflächenbeschichtung. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächenbeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die in der LED entsteht. Diese Wärme führt zu einer Verringerung der Fluoreszenzquantenausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

Bevorzugt sind Oberflächenbeschichtungen, die aus SiO₂, TiO₂, Al₂O₃, ZnO, ZrO₂ und/oderY₂O₃ oder Mischoxiden daraus bestehen.

In einer weiteren bevorzugten Ausführungsform besitzen die Leuchtstoffpartikel eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und/oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Maße eingestellt werden. Damit wird die Verarbeitung der Gemische vereinfacht.

Ein weiterer Gegenstand der vorliegenden Erfindung ist auch die Verwendung der erfindungsgemäßen Verbindungen der Formel I als Leuchtstoffe, insbesondere als Konversionsleuchtstoffe.

Unter dem Begriff "Konversionsleuchtstoff" wird in der vorliegenden Anmeldung ein Material verstanden, das in einem bestimmten Wellenlängenbereich des elektromagnetischen Spektrums, vorzugsweise im blauen oder im UV-Spektralbereich, Strahlung absorbiert und in einem anderen Wellenlängenbereich des elektromagnetischen Spektrums, vorzugsweise im roten, orangen, gelben oder grünen Spektralbereich, insbesondere im grünen Spektralbereich, sichtbares Licht emittiert.

In diesem Zusammenhang ist auch der Begriff "strahlungsinduzierte Emissionseffizienz" zu verstehen, d. h. der Konversionsleuchtstoff absorbiert Strahlung in einem bestimmten Wellenlängenbereich und emittiert Strahlung in einem anderen Wellenlängenbereich mit einer bestimmten Effizienz. Die Steigerung der Emissionseffizienz wird in der Steigerung der emittierten Lichtintensität gemessen.

Unter dem Begriff "Verschiebung der Emissionswellenlänge" versteht man, dass ein Konversionsleuchtstoff im Vergleich zu einem anderen oder ähnlichen Konversionsleuchtstoff Licht bei einer anderen Wellenlänge emittiert, das heißt verschoben zu einer kleineren oder größeren Wellenlänge. Es wird also das Emissionsmaximum verschoben.

Ein weiterer Gegenstand der vorliegenden Erfindung ist eine Leuchtstoffmischung enthaltend die erfindungsgemäßen Verbindungen der Formel I. Die Leuchtstoffmischung kann ausschließlich aus erfindungsgemäßen Verbindungen der Formel I bestehen und wäre in diesem Fall mit dem oben definierten Begriff "Leuchtstoff bzw. Konversionsleuchtstoff" gleichzusetzen.

Es ist auch möglich, dass die erfindungsgemäße Leuchtstoffmischung neben der erfindungsgemäßen Verbindung der Formel I noch weitere Konversionsleuchtstoffe enthält. In diesem Fall enthält die erfindungsgemäße Leuchtstoffmischung eine Mischung aus mindestens zwei Konversionsleuchtstoffen, wobei einer davon ein erfindungsgemäßer Konversionsleuchtstoff ist. Es ist mindestens bevorzugt, dass die zwei Konversionsleuchtstoffe Leuchtstoffe sind, welche Licht unterschiedlicher Wellenlängen emittieren, die vorzugsweise komplementär zueinander sind. Der erfindungsgemäße grün-emittierende Konversionsleuchtstoff kann in Kombination mit blau- und rot-emittierenden Konversionsleuchtstoffen eingesetzt werden (RGB-Konzept). Alternativ dazu kann auch der erfindungsgemäße Konversionsleuchtstoff in Kombination mit einem rot-emittierenden Konversionsleuchtstoff eingesetzt werden. Es kann also bevorzugt sein, dass der erfindungsgemäße Konversionsleuchtstoff in Kombination mit einem oder mehreren weiteren Konversionsleuchtstoffen in der erfindungsgemäßen Leuchtstoffmischung eingesetzt wird, die dann zusammen vorzugsweise weißes Licht emittieren.

Als weiterer Konversionsleuchtstoff, der zusammen mit den erfindungsgemäßen Verbindungen eingesetzt werden kann, kann generell jeder mögliche Konversionsleuchtstoff eingesetzt werden. Dabei eignen sich beispielsweise:
Ba₂SiO₄:Eu²⁺, BaSi₂O₅:Pb²⁺, BaₓSr₁₋ₓF₂:Eu²⁺, BaSrMgSi₂O₇:Eu²⁺, BaTiP₂O₇, (Ba,Ti)₂P₂O₇:Ti, Ba₃WO₆:U, BaY₂F₈:Er³⁺,Yb⁺, Be₂SiO₄:Mn²⁺, Bi₄Ge₃O₁₂, CaAl₂O₄:Ce³⁺, CaLa₄O₇:Ce³⁺, CaAl₂O₄:Eu²⁺, CaAl₂O₄:Mn²⁺, CaAl₄O₇:Pb²⁺,Mn²⁺, CaAl₂O₄:Tb³⁺, Ca₃Al₂Si₃O₁₂:Ce³⁺ Ca₃Al₂Si₃Oi₂:Ce³⁺, Ca₃Al₂Si₃O_{,2}:Eu²⁺, Ca₂B₅O₉Br:Eu²⁺, Ca₂B₅O₉Cl:EU²⁺, Ca₂B₅O₉Cl:Pb²⁺, CaB₂O₄:Mn²⁺, Ca₂B₂O₅:Mn²⁺, CaB₂O₄:Pb²⁺, CaB₂P₂O₉:Eu²⁺, Ca₅B₂SiO₁₀:Eu³⁺, Ca_{0.5}Ba_{0.5}Al₁₂O₁₉:Ce³⁺, Mn²⁺, Ca₂Ba₃(PO₄)₃Cl:Eu²⁺, CaBr₂:Eu²⁺ in SiO₂, CaCl₂:Eu²⁺ in SiO₂, CaCl₂:Eu²⁺, Mn²⁺ in SiO₂, CaF₂:Ce³⁺, CaF₂:Ce³⁺,Mn²⁺, CaF₂:Ce³⁺,Tb³⁺, CaF₂:Eu²⁺, CaF₂:Mn²⁺, CaF₂:U, CaGa₂O₄:Mn²⁺, CaGa₄O₇:Mn²⁺, CaGa₂S₄:Ce³⁺, CaGa₂S₄:Eu²⁺, CaGa₂S₄:Mn²⁺, CaGa₂S₄:Pb²⁺, CaGeO₃:Mn²⁺, Cal₂:Eu²⁺ in SiO₂, Cal₂:EU²⁺, Mn²⁺ in SiO₂, CaLaBO₄:Eu³⁺, CaLaB₃O₇:Ce³⁺,Mn²⁺, Ca₂La₂BO_{6.5}:Pb²⁺, Ca₂MgSi₂O₇, Ca₂M₉Si₂O₇:Ce³⁺, CaMgSi₂O₆:Eu²⁺, Ca₃MgSi₂O₈:Eu²⁺, Ca₂MgSi₂O₇:Eu²⁺, CaMgSi₂O₆:Eu²⁺, Mn²⁺, Ca₂MgSi₂O₇:Eu²⁺, Mn²⁺, CaMoO₄, CaMoO₄:Eu³⁺, CaO:Bi³⁺, CaO:Cd²⁺, CaO:Cu⁺, CaO:Eu³⁺, CaO:Eu³⁺, Na⁺, CaO:Mn²⁺, CaO:Pb²⁺, CaO:Sb³⁺, CaO:Sm³⁺, CaO:Tb³⁺, CaO:TI, CaO:Zn²⁺, Ca₂P₂O₇:Ce³⁺, α-Ca₃(PO₄)₂:Ce³⁺, β-Ca₃(PO₄)₂:Ce³⁺, Ca₅(PO₄)₃Cl:Eu²⁺, Ca₅(P0₄)₃Cl:Mn²⁺, Ca₅(PO₄)₃Cl:Sb³⁺, Ca₅(PO₄)₃Cl:Sn²⁺, β-Ca₃(PO₄)₂:Eu²⁺, Mn²⁺, Ca₅(PO₄)₃F:Mn²⁺, Caₛ(PO₄)₃F:Sb³⁺, Caₛ(PO₄)₃F:Sn²⁺, α-Ca₃(PO₄)₂:Eu²⁺, β-Ca₃(PO₄)₂:EU²⁺, Ca₂P₂O₇:Eu²⁺, Ca₂P₂O₇:Eu²⁺, Mn²⁺, CaP₂O₆:Mn²⁺, α-Ca₃(PO₄)₂:Pb²⁺, α-Ca₃(PO₄)₂:Sn²⁺, β-Ca₃(PO₄)₂:Sn²⁺, β-Ca₂P₂O₇:Sn,Mn, α-Ca₃(PO₄)₂:Tr, CaS:Bi³⁺, CaS:Bi³⁺, Na, CaS:Ce³⁺, CaS:Eu²⁺, CaS:Cu⁺, Na⁺, CaS:La³⁺, CaS:Mn²⁺, CaSO₄:Bi, CaSO₄:Ce³⁺, CaSO₄:Ce³⁺, Mn²⁺, CaSO₄:Eu²⁺, CaSO₄:Eu²⁺, Mn²⁺, CaSO₄:Pb²⁺, CaS:Pb²⁺, CaS:Pb²⁺, Cl, CaS:Pb²⁺, Mn²⁺, CaS:Pr³⁺, Pb²⁺, Cl, CaS:Sb³⁺, CaS:Sb³⁺, Na, CaS:Sm³⁺, CaS:Sn²⁺, CaS:Sn²⁺, F, CaS:Tb³⁺, CaS:Tb³⁺, Cl, CaS:Y³⁺, CaS:Yb²⁺, CaS:Yb²⁺, Cl, CaSiO₃:Ce³⁺, Ca₃SiO₄Cl₂:Eu²⁺, Ca₃SiO₄Cl₂:Pb²⁺, CaSiO₃:Eu²⁺, CaSiO₃:Mn²⁺, Pb, CaSiO₃:Pb²⁺, CaSiO₃:Pb²⁺, Mn²⁺, CaSiO₃:Ti⁴⁺, CaSr₂(PO₄)₂:Bi³⁺, β-(Ca,Sr)₃(PO₄)₂:Sn²⁺Mn²⁺, CaTi_{0.1}Al_{0.1}O₃:Bi³⁺, CaTiO₃:Eu³⁺, CaTiO₃:Pr³⁺, Ca₅(VO₄)₃Cl, CaWO₄, CaWO₄:Pb²⁺, CaWO₄:W, Ca₃WO₆:U, CaYAlO₄:Eu³⁺, CaYBO₄:Bi³⁺, CaYBO₄:Eu³⁺, CaYB_{0.8}O_{3.7}:Eu³⁺, CaY₂ZrO₆:Eu³⁺, (Ca,Zn,Mg)₃(PO₄)₂:Sn, CeF₃, (Ce,Mg)BaAl₁₁O₁₈:Ce, (Ce,Mg)SrA)₁₁O₁₈:Ce, CeMgAl₁₁O₁₉:Ce:Tb, Cd₂B₆O₁₁:Mn²⁺, CdS:Ag⁺, Cr, CdS:ln, CdS:ln, CdS:ln, Te, CdS:Te, CdWO₄, CsF, Csl, Csl:Na⁺, Csl:Tl, (ErCl₃)_{0.25}(BaCl₂)_{0.75}, GaN:Zn, Gd₃Ga₅O₁₂:Cr³⁺, Gd₃Ga₅O₁₂:Cr,Ce, GdNbO₄:Bi³⁺, Gd₂O₂S:Eu³⁺, Gd₂O₂Pr³⁺, Gd₂O₂S:Pr,Ce,F, Gd₂O₂S:Tb³⁺, Gd₂SiO₅:Ce³⁺, KAI₁₁O₁₇:TI⁺, KGa₁₁O₁₇:Mn²⁺, K₂La₂Ti₃O₁₀:Eu, KMgF₃:Eu²⁺, KMgF₃:Mn²⁺, K₂SiF₆:Mn⁴⁺, LaAl₃B₄O₁₂:Eu³⁺, LaAlB₂O₆:Eu³⁺, LaAlO₃:Eu³⁺, LaAlO₃:Sm³⁺, LaAsO₄:Eu³⁺, LaBr₃:Ce³⁺, LaBO₃:Eu³⁺, (La,Ce,Tb)PO₄:Ce:Tb, LaCl₃:Ce³⁺, La₂O₃:Bi³⁺, LaOBr:Tb³⁺, LaOBr:Tm³⁺, LaOCl:Bi³⁺, LaOCl:Eu³⁺, LaOF:Eu³⁺, La₂O₃:Eu³⁺, La₂O₃:Pr³⁺, La₂O₂S:Tb³⁺, LaPO₄:Ce³⁺, LaPO₄:Eu³⁺, LaSiO₃Cl:Ce³⁺, LaSiO₃Cl:Ce³⁺,Tb³⁺, LaVO₄:Eu³⁺, La₂W₃O₁₂:Eu³⁺, LiAlF₄:Mn²⁺, LiAl₅O₈:Fe³⁺, LiAlO₂:Fe³⁺, LiAlO₂:Mn²⁺, LiAl₅O:Mn²⁺, Li₂CaP₂O₇:Ce³⁺,Mn²⁺, LiCeBa₄Si₄O₁₄:Mn²⁺, LiCeSrBa₃Si₄O₁₄:Mn²⁺, LilnO₂:Eu³⁺, LiInO₂:Sm³⁺, LiLaO₂:Eu³⁺, LuAlO₃:Ce³⁺, (Lu,Gd)₂SiO₅:Ce³⁺, Lu₂SiO₅:Ce³⁺, Lu₂Si₂O₇:Ce³⁺, LuTaO₄:Nb⁵⁺, Lu₁₋ₓYₓAlO₃:Ce³⁺, MgAl₂O₄:Mn²⁺, MgSrAl₁₀O1₇:Ce, MgB₂O₄:Mn²⁺, MgBa₂(PO₄)₂:Sn²⁺ MgBa₂(PO₄)₂:U, MgBaP₂O₇:Eu²⁺, MgBaP₂O₇:Eu²⁺,Mn²⁺, MgBa₃Si₂O₈:Eu²⁺, MgBa(SO₄)₂:Eu²⁺, Mg₃Ca₃(PO₄)₄:Eu²+, MgCaP₂O₇:Mn²⁺, Mg₂Ca(SO₄)₃:Eu²⁺, Mg₂Ca(SO₄)₃:Eu²⁺,Mn², MgCeAlₙO₁₉:Tb³⁺, Mg₄(F)GeO₆:Mn²⁺, Mg₄(F)(Ge,Sn)O₆:Mn²⁺, MgF₂:Mn²⁺, MgGa₂O₄:Mn²⁺, Mg₈Ge₂O₁₁F₂:Mn⁴⁺, MgS:Eu²⁺, MgSiO₃:Mn²⁺, Mg₂SiO₄:Mn²⁺, Mg₃SiO₃F₄:Ti⁴⁺, MgSO₄:Eu²⁺, MgSO₄:Pb²⁺, MgSrBa₂Si₂O₇:Eu²⁺, MgSrP₂O₇:Eu²⁺, MgSr₅(PO₄)₄:Sn²⁺, MgSr₃Si₂O₈:Eu²⁺,Mn²⁺, Mg₂Sr(SO₄)₃:Eu²⁺, Mg₂TiO₄:Mn⁴⁺, MgWO₄, MgYBO₄:Eu³⁺, Na₃Ce(PO₄)₂:Tb³⁺, Nal:TI, Na_{1.23}K_{0.42}EU_{0.12}TiSi₄O₁₁:Eu³⁺, Na_{1.23}K_{0.42}EU_{0.12}TiSi₅O₁₃·XH₂O:Eu³⁺, Na_{1.29}K_{0.46}Er_{0.08}TiSi₄O₁₁:EU³⁺ Na₂Mg₃Al₂Si₂O₁₀:Tb, Na(Mg₂₋ₓMnₓ)LiSi₄O₁₀F₂:Mn, NaYF₄:Er³⁺, Yb³⁺, NaYO₂:Eu³⁺, P46(70%) + P47 (30%), SrAl₁₂O₁₉:Ce³⁺, Mn²⁺, SrAl₂O₄:Eu²⁺, SrAl₄O₇:Eu³⁺, SrAl₁₂O₁₉:Eu²⁺, SrAl₂S₄:Eu²⁺, Sr₂B₅O₉Cl:Eu²⁺, SrB₄O₇:Eu²⁺(F,Cl,Br), SrB₄O₇:Pb²⁺, SrB₄O₇:Pb²⁺, Mn²⁺, SrB₈O₁₃:SM²⁺, SrₓBa_{y}Cl_{z}Al₂O_{4-z/2}: Mn²⁺, Ce³⁺, SrBaSiO₄:Eu²⁺, Sr(Cl,Br,I)₂:Eu²⁺ in SiO₂, SrCl₂:Eu²⁺ in SiO₂, Sr₅Cl(PO₄)₃:Eu, Sr_{w}FₓB₄O_{6.5}:EU²⁺, Sr_{w}FₓB_{y}O_{z}:Eu²⁺,Sm²⁺, SrF₂:Eu²⁺, SrGa₁₂O₁₉:Mn²⁺, SrGa₂S₄:Ce³⁺, SrGa₂S₄:Eu²⁺, SrGa₂S₄:Pb²⁺, SrIn₂O₄:Pr³⁺, Al³⁺, (Sr,Mg)₃(PO₄)₂:Sn, SrMgSi₂O₆:Eu²⁺, Sr₂MgSi₂O₇:Eu²⁺, Sr₃MgSi₂O₈:Eu²⁺, SrMoO₄:U, SrO·3B₂O₃:Eu²⁺,Cl, β-SrO·3B₂O₃:Pb²⁺, β-SrO·3B₂O₃:Pb²⁺,Mn²⁺, α-SrO·3B₂O₃:Sm²⁺, Sr₆P₅BO₂₀:Eu, Sr₅(PO₄)₃Cl:Eu²⁺, Sr₅(PO₄)₃Cl:Eu²⁺,Pr³⁺, Sr₅(PO₄)₃Cl:Mn²⁺, Sr₅(PO₄)₃Cl:Sb³⁺, Sr₂P₂O₇:Eu²⁺, β-Sr₃(PO₄)₂:Eu²⁺, Sr₅(PO₄)₃F:Mn²⁺, Sr₅(PO₄)₃F:Sb³⁺, Sr₅(PO₄)₃F:Sb³⁺,Mn²⁺, Sr₅(PO₄)₃F:Sn²⁺, Sr₂P₂O₇:Sn²⁺, β-Sr₃(PO₄)₂:Sn²⁺, β-Sr₃(PO₄)₂:Sn²⁺,Mn²⁺(Al), SrS:Ce³⁺, SrS:Eu²⁺, SrS:Mn²⁺, SrS:Cu⁺,Na, SrSO₄:Bi, SrSO₄:Ce³⁺, SrSO₄:Eu²⁺, SrSO₄:Eu²⁺,Mn²⁺, Sr₅Si₄O₁₀Cl₆:Eu²⁺, Sr₂SiO₄:Eu²⁺, SrTiO₃:Pr³⁺, SrTiO₃:Pr³⁺,Al³⁺, Sr₃WO₆:U, SrY₂O₃:Eu³⁺, ThO₂:Eu³⁺, ThO₂:Pr³⁺, ThO₂:Tb³⁺, YAl₃B₄O₁₂:Bi³⁺, YAl₃B₄O₁₂:Ce³⁺, YAl₃B₄O₁₂:Ce³⁺,Mn, YAl₃B₄O₁₂:Ce³⁺,Tb³⁺, YAl₃B₄O₁₂:Eu³⁺, YAl₃B₄O₁₂:Eu³⁺,Cr³⁺, YAl₃B₄O₁₂:Th⁴⁺,Ce³⁺,Mn²⁺, YAlO₃:Ce³⁺, Y₃Al₅O₁₂:Ce³⁺, Y₃Al₅O₁₂:Cr³⁺, YAlO₃:Eu³⁺, Y₃Al₅O₁₂:Eu^{3r}, Y₄Al₂O₉:Eu³⁺, Y₃Al₅O₁₂:Mn⁴⁺, YAlO₃:Sm³⁺, YAlO₃:Tb³⁺, Y₃,Al₅O₁₂:Tb³⁺, YAsO₄:Eu³⁺, YBO₃:Ce³⁺, YBO₃:Eu³⁺, YF₃:Er³⁺,Yb³⁺, YF₃:Mn²⁺, YF₃:Mn²⁺,Th⁴⁺, YF₃:Tm³⁺,Yb³⁺, (Y,Gd)BO₃:Eu, (Y,Gd)BO₃:Tb, (Y,Gd)₂O₃:Eu³⁺, Y_{1.34}Gd_{0.60}O₃(EU,Pr), Y₂O₃:Bi³⁺, YOBr:Eu³⁺, Y₂O₃:Ce, Y₂O₃:Er³⁺, Y₂O₃:Eu³⁺(YOE), Y₂O₃:Ce³⁺,Tb³⁺, YOCl:Ce³⁺, YOCl:Eu³⁺, YOF:Eu³⁺, YOF:Tb³⁺, Y₂O₃:H_{O}³⁺, Y₂OY₂O₂S:Pr³⁺, Y₂O₂S:Tb³⁺, Y₂O₃:Tb³⁺, YPO₄:Ce³⁺, YPO₄:Ce³⁺,Tb³⁺, YPO₄:Eu³⁺, YPO₄:Mn²⁺,Th⁴⁺, YPO₄:V⁵⁺, Y(P,V)O₄:Eu, Y₂SiO₅:Ce³⁺, YTaO₄, YTaO₄:Nb⁵⁺, YVO₄:Dy³⁺, YVO₄:Eu³⁺, ZnAl₂O₄:Mn²⁺, ZnB₂O₄:Mn²⁺, ZnBa₂S₃:Mn²⁺, (Zn,Be)₂SiO₄:Mn²⁺, Zn_{0.4}Cd_{0.6}S:Ag, Zn_{0.6}Cd_{0.4}S:Ag, (Zn,Cd)S:Ag,Cl, (Zn,Cd)S:Cu, ZnF₂:Mn²⁺, ZnGa₂O₄, ZnGa₂O₄:Mn²⁺, ZnGa₂S₄:Mn²⁺, Zn₂GeO₄:Mn²⁺, (Zn,Mg)F₂:Mn²⁺, ZnMg₂(PO₄)₂:Mn²⁺, (Zn,Mg)₃(PO₄)₂:Mn²⁺, ZnO:Al³⁺,Ga³⁺, ZnO:Bi³⁺, ZnO:Ga³⁺, ZnO:Ga, ZnO-CdO:Ga, ZnO:S, ZnO:Se, ZnO:Zn, ZnS:Ag⁺,Cl⁻, ZnS:Ag,Cu,Cl, ZnS:Ag,Ni, ZnS:Au,In, ZnS-CdS (25-75), ZnS-CdS (50-50), ZnS-CdS (75-25), ZnS-CdS:Ag,Br,Ni, ZnS-CdS:Ag⁺,Cl, ZnS-CdS:Cu,Br, ZnS-CdS:Cu,I, ZnS:Cl⁻, ZnS:Eu²⁺, ZnS:Cu, ZnS:Cu⁺,Al³⁺, ZnS:Cu+,Cl⁻, ZnS:Cu,Sn, ZnS:Eu²⁺, ZnS:Mn²⁺, ZnS:Mn,Cu, ZnS:Mn²⁺,Te²⁺, ZnS:P, ZnS:P³⁻,Cl⁻, ZnS:Pb²⁺, ZnS:Pb²⁺,Cl⁻, ZnS:Pb,Cu, Zn₃(PO₄)₂:Mn²⁺, Zn₂SiO₄:Mn²⁺, Zn₂SiO₄:Mn²⁺,As⁵⁺, Zn₂SiO₄:Mn,Sb₂O₂, Zn₂SiO₄:Mn²⁺,P, Zn₂SiO₄:Ti⁴⁺, ZnS:Sn²⁺, ZnS:Sn,Ag, ZnS:Sn²⁺,Li⁺, ZnS:Te,Mn, ZnS-ZnTe:Mn²⁺, ZnSe:Cu⁺,Cl oder ZnWO₄.

Ein weiterer Gegenstand der vorliegenden Erfindung ist die Verwendung der erfindungsgemäßen Leuchtstoffmischung in einer Lichtquelle. Besonders bevorzugt ist die Lichtquelle eine LED, insbesondere eine phosphorkonvertierte LED, kurz pc-LED. Hierbei ist es besonders bevorzugt, dass die Leuchtstoffmischung neben dem erfindungsgemäßen grün-emittierenden Konversionsleuchtstoff mindestens einen weiteren, vorzugsweise rot-emittierenden, Konversionsleuchtstoff umfasst, insbesondere so, dass die Lichtquelle insgesamt weißes Licht oder aber auch in einer anderen bevorzugten Ausführungsform Licht mit einem bestimmten Farbpunkt (Color-on-demand-Prinzip) emittiert.

Unter dem color-on-demand Konzept versteht man die Realisierung von Licht eines bestimmten Farbpunktes mit einer pcLED (= phosphor converted LED) unter Einsatz eines oder mehrere Leuchtstoffe. Dieses Konzept wird z.B. verwendet, um bestimmte Corporate Designs, z.B. für beleuchtete Firmenlogos, Marken etc. zu erzeugen.

Die LED-Qualität wird dabei über übliche Parameter, wie beispielsweise den Color Rendering Index oder den Farbpunkt in CIE x und CIE y Koordinaten beschrieben.

Der Color Rendering Index oder CRI ist eine, dem Fachmann geläufige, einheitslose lichttechnische Grösse, welche die Farbwiedergabetreue einer künstlichen Lichtquelle mit derjenigen des Sonnenlichtes bzw. Filamentlichtquellen vergleicht (die beiden letztgenannten besitzen einen CRI von 100).

CIE x und CIE y stehen für die Koordinaten in dem, dem Fachmann geläufigen, CIE Normfarbdiagramm (hier Normalbeobachter 1931), mit denen die Farbe einer Lichtquelle beschrieben wird.
Alle oben aufgeführten Größen werden nach, dem Fachmann geläufigen, Methoden aus Emissionsspektren der Lichtquelle berechnet.

Ein weiterer Gegenstand der vorliegenden Erfindung ist somit eine Lichtquelle, die eine Primärlichtquelle und eine erfindungsgemäße Leuchtstoffmischung umfasst.

Auch hier ist es insbesondere bevorzugt, dass die Leuchtstoffmischung neben dem erfindungsgemäßen grün-emittierenden Konversionsleuchtstoff mindestens einen weiteren, vorzugsweise rot-emittierenden Konversionsleuchtstoff umfasst, so dass die Lichtquelle vorzugsweise weißes Licht oder in einer weiteren bevorzugten Ausführungsform Licht mit einem bestimmten Farbpunkt emittiert.

Die erfindungsgemäße Lichtquelle ist vorzugsweise eine pc-LED. Eine pc-LED enthält in der Regel eine Primärlichtquelle und eine erfindungsgemäße Leuchtstoffmischung.

Die Primärlichtquelle kann ein Halbleiterchip, eine lumineszente Lichtquelle, wie ZnO, eine sogenanntes TCO (Transparent Conducting Oxide), eine auf ZnSe oder SiC basierende Anordnung, eine auf einer organischen Lichtemittierenden Schicht basierende Anordnung (OLED) oder eine Plasma- oder Entladungsquelle sein, am stärksten bevorzugt ein Halbleiterchip. Dem Fachmann sind mögliche Formen von derartigen Primärlichtquellen bekannt.

Ist die Primärlichtquelle ein Halbleiterchip, so handelt es sich vorzugsweise um ein lumineszentes Indium-Aluminium-Gallium-Nitrid (InAlGaN), wie es im Stand der Technik bekannt ist.

In einer bevorzugten Ausführungsform enthält die erfindungsgemäße Lichtquelle eine UV-Licht emittierende Primärlichtquelle, vorzugsweise eine UV-LED mit 1 W Leistungsaufnahme und einer Emission bei 390 nm, und eine Leuchtstoffmischung enthaltend einen oder mehrere grün-emittierende Konversionsleuchtstoffe der Formel I, vorzugsweise ausgewählt aus Verbindungen der Formeln V-5 und V-6 im Mischungsverhältnis 1:1 (% w/w) und optional einen oder mehrere rot-emittierende Konversionsleuchtstoffe, vorzugsweise ausgewählt aus der Gruppe der Nitride, besonders bevorzugt ausgewählt aus der Gruppe (Sr,Ca,Ba)₂Si₅N₈:Eu, (Ca,Sr)AlSiN₃:Eu) und/oder der aus WO 2011/091839 A1 (Merck) bekannten Oxynitride im Verhältnis 80:20 (% w/w) erfindungsgemäßer Leuchtstoff zu rot-emittierenden Konversionsleuchtstoff.

In einer weiteren bevorzugten Ausführungsform enthält die erfindungsgemäße Lichtquelle eine blau-emittierende Primärlichtquelle, vorzugsweise eine LED mit 1 W Leistungsaufnahme und einer Emission bei 447 nm, und eine Leuchtstoffmischung enthaltend einen oder mehrere grün-emittierende Konversionsleuchtstoffe der Formel I, vorzugsweise ausgewählt aus Verbindungen der Formeln V-5 und optional einen oder mehrere rot-emittierende Konversionsleuchtstoffe, vorzugsweise ausgewählt aus der Gruppe der Nitride, besonders bevorzugt ausgewählt aus der Gruppe (Sr,Ca,Ba)₂Si₅N₈:Eu, (Ca,Sr)AlSiN₃:Eu) und/oder der aus WO 2011/091839 A1 (Merck) bekannten Oxynitride im Verhältnis 80:20 (% w/w) erfindungsgemäßer Konversionsleuchtstoff zu rot-emittierenden Konversionsleuchtstoff.

Da die auf einer Primärlichtquelle aufgebrachte Leuchtstoffmischung vorzugsweise aus einem Gemisch von Silikon und homogenen Leuchtstoffpartikeln besteht, welches im Volumenguss aufgebracht wird, und das Silikon eine Oberflächenspannung aufweist, ist diese Schicht der Leuchtstoffmischung auf mikroskopischer Ebene nicht einheitlich bzw. ist die Dicke der Schicht nicht durchweg konstant. Dies ist in der Regel auch der Fall wenn die Leuchtstoffmischung nicht nach dem Volumengussverfahren, sondern im sogenannten Chip-Level-Konversionsverfahren, bei dem eine hochkonzentrierte, dünne Schicht der Leuchtstoffmischung mit Hilfe von elektrostatischen Methoden direkt auf die Oberfläche der Primärlichtquelle aufgebracht wird.

Mit Hilfe des oben genannten Verfahrens können beliebige äußere Formen oder Leuchtstoffkörper aus der Leuchtstoffmischung hergestellt werden, wie sphärische Partikel, Plättchen und strukturierte Materialien und Keramiken.

Die Herstellung der Leuchtstoffkörper in Plättchenform als weitere bevorzugte Ausführungsform geschieht nach herkömmlichen Verfahren aus den entsprechenden Halbmetall-, Metall- und Seltenerd-Salzen. Das Herstellverfahren ist in EP 763573 und DE 102006054331 ausführlich beschrieben, welche voll umfänglich in den Kontext der vorliegenden Anmeldung durch Bezugnahme eingefügt werden. Diese Plättchen können hergestellt werden, indem ein natürlicher oder synthetisch hergestellter hoch stabiler Träger bzw. ein Substrat aus beispielsweise Glimmer-, SiO₂-, Al₂O₃-, ZrO₂-, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Schicht der Leuchtstoffmischung beschichtet werden kann. Neben Glimmer, ZrO₂, SiO₂, Al₂O₃, Glas oder TiO₂ oder Gemischen derselben können die Plättchen auch aus der Leuchtstoffmischung selbst bestehen, oder aus einem anderen Material aufgebaut sein. Falls das Plättchen selbst lediglich als Träger der Leuchtstoffmischung dient, muss dieses aus einem Material bestehen, welches transparent für die Primärstrahlung der Primärlichtquelle ist, oder die Primärstrahlung absorbiert und diese Energie auf die Leuchtstoffmischung überträgt. Die plättchenförmigen Leuchtstoffkörper werden in einem Harz (z.B. Silikon- oder Epoxidharz), dispergiert und diese Dispersion wird auf die Primärlichtquelle aufgebracht.

Die Plättchen können hierbei in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm.

Die Plättchen besitzen in der Regel ein Aspektverhältnis (Verhältnis des Durchmessers zur Teilchendicke) von 1: 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die der Primärlichtquelle zugewandte Oberfläche der erfindungsgemäßen plättchenförmigen Leuchtstoffkörper kann mit einer Beschichtung versehen werden, welche entspiegelnd in Bezug auf die von der Primärlichtquelle emittierte Primärstrahlung wirkt. Dies führt zu einer Verringerung der Rückstreuung der Primärstrahlung, wodurch diese besser in die erfindungsgemäßen Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung der Primärlichtquelle /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen, wobei hierunter auch eine Strukturierung der Oberfläche der plättchenförmigen Leuchtstoffkörper fällt, um bestimmte Funktionalitäten zu erreichen.

Ein weiterer Gegenstand der vorliegenden Erfindung ist ein erfindungsgemäßer Leuchtstoff in Form eines keramischen Körpers. Bei keramischen Leuchtstoffkörpern finden keine ortsabhängigen Variationen der Anregung und Emission der Leuchtstoffkörper statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Plättchen des Leuchtstoffkörpers über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneiden der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.
Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund einer Primärlichtquelle fixiert werden.

In einer weiteren Ausführungsform besitzt der keramische Leuchtstoffkörper auf der, einer Primärlichtquelle entgegengesetzten Seite eine strukturierte (z.B. pyramidale) Oberfläche. Somit kann möglichst viel Licht aus dem Leuchtstoffkörper ausgekoppelt werden.

Die Herstellung der Leuchtstoffkörper in Form von keramischen Körpern erfolgt beispielsweise nach dem in DE 102006037730 (Merck) beschriebenen Verfahren, die voll umfänglich in den Kontext der vorliegenden Anmeldung durch Bezugnahme eingefügt wird aber auch andere, dem Fachmann bekannte, Verfahren können zur Herstellung der keramischen Leuchtstoffkörper wie beispielsweise Sintern herangezogen werden.

Vorzugsweise wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche der Primärlichtquelle aufgebracht. Eine strukturierte Oberfläche auf dem Leuchtstoffkörper wird vorzugsweise dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Ein weiterer Erfindungsgegenstand ist eine Beleuchtungseinheit, die mindestens eine erfindungsgemäße Lichtquelle enthält. Solche Beleuchtungseinheiten werden unter anderem in Anzeigevorrichtungen, insbesondere Flüssigkristallanzeigevorrichtungen (LC-Display) mit einer Hintergrundbeleuchtung eingesetzt. Gerade für die Anwendungen in einem Flüssigkristalldisplay ist es von besonderer Bedeutung, dass die emittierenden Leuchtstoffe eine schmalbandige Emissionsbande außerhalb des Absorptionsbereiches des Farbfilters aufweisen, um eine hohe Transmission zu gewährleisten.

In der erfindungsgemäßen Beleuchtungseinheit erfolgt die optische Ankopplung zwischen dem Leuchtstoffkörper und der Primärlichtquelle (insbesondere Halbleiterchips) vorzugsweise durch eine lichtleitende Anordnung. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoffkörper optisch angekoppelt ist. Auf diese Weise lassen sich den Beleuchtungswünschen angepasste Leuchtstoffkörper enthaltend einen oder mehrere der erfindungsgemäßen Konversionsleuchtstoffe, vorzugsweise ausgewählt aus den Verbindungen der Formel V-5, die zu einem Leuchtschirm angeordnet sein können, und einem Lichtleiter, der an die Primärlichtquelle angekoppelt ist, realisieren.

Dadurch ist es möglich, eine starke Primärlichtquelle an einem für die elektrische Installation günstigen Ort zu platzieren und ohne weitere elektrische Verkabelung, nur durch Verlegung von Lichtleitern an beliebigen Orten, Leuchtstoffkörper enthaltend einen oder mehrere der erfindungsgemäßen Leuchtstoffe, welche an die Lichtleiter gekoppelt sind, zu installieren.

Weiterhin bevorzugt ist eine Beleuchtungseinheit, insbesondere zur Allgemeinbeleuchtung, die dadurch gekennzeichnet ist, dass sie einen CRI (=color rendering index) > 60, vorzugsweise > 70, noch stärker bevorzugt >85 aufweist. CRI-Werte > 85 können allerdings nur realisiert werden, wenn der erfindungsgemäße Konversionsleuchtstoff nach Formel I, vorzugsweise ausgewählt aus den Verbindungen der Formel V-6, zusätzlich mit rot-emittierenden Leuchtstoffen vorzugsweise ausgewählt aus der Gruppe der Nitride, besonders bevorzugt ausgewählt aus der Gruppe (Sr,Ca,Ba)₂Si₅N₈:Eu, (Ca,Sr)AlSiN₃:Eu) und/oder der aus WO 2011/091839 A1 (Merck) bekannten Oxynitride im Verhältnis 80:20 (% w/w) erfindungsgemäßer Konversionsleuchtstoff zu rot-emittierenden Konversionsleuchtstoff, in der LED kombiniert wird.

Ein weiterer Gegenstand der vorliegenden Erfindung ist die Verwendung der erfindungsgemäßen Leuchtstoffe als Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und kommerziell erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung von Sr_{0,96}Eu_{0,04}Al₁₀MgSiO₁₉

2,28 g Strontiumcarbonat (0,015 mol), 21,70 g basisches Aluminiumcarbonat (0,081 mol, Alfa Aesar), 1,37 g Magnesiumcarbonat (0,016 mol, Acros), 0,975 g Siliciumdioxid (0,016 mol, Aldrich) und 0,142 g Europiumoxid (0,004 mol, Treibacher) werden in einem Handmörser homogenisiert. Die Mischung wird unter Luft 4 Stunden bei 1000°C kalziniert. Die so erhaltene Leuchtstoff-Vorstufe wird anschließend für 4 Stunden bei 1300°C unter Stickstoff-Wasserstoffatmosphäre (10 % Wasserstoff-Anteil) kalziniert. Der Rohleuchtstoff wird anschließend mittels Handmörser zerkleinert, gesiebt (Porengröße < 36 µm) und spektroskopisch charakterisiert.

### Beispiel 2: Blaue LED als Primärlichtquelle

1.1 g eines grünen Leuchtstoffs mit der chemischen Zusammensetzung Sr_{0,96}Eu_{0,04}Al₁₀MgSiO₁₉ und 5 g eines roten Leuchtstoffs mit der chemischen Zusammensetzung Sr_{1,94}EU_{0,06}Si₅N_{7,67}O_{0,5} werden eingewogen und in einem Speedmixer homogen vermischt. Diese Leuchtstoffmischung wird dann in einer Konzentration von 8 % w/w in einem optisch transparenten Silikon dispergiert. Das so erhaltene Silikon-Leuchtstoff-Gemisch wird mit Hilfe eines automatischen Dispensers auf den Chip einer blauen Halbleiter-LED (LED mit 1 W Leistungsaufnahme und einer Emission bei 447 nm) aufgebracht und unter Wärmezufuhr ausgehärtet.

### Beispiel 3: UV-LED als Primärlichtquelle

2. 1 g eines grünen Leuchtstoffs mit der chemischen Zusammensetzung Sr_{0,96}Eu_{0,04}Al₁₀M₉SiO₁₉ und 5 g eines roten Leuchtstoffs mit der chemischen Zusammensetzung Sr_{1,94}Eu_{0,06}Si₅N_{7,67}O_{0,5} werden eingewogen und in einem Speedmixer homogen vermischt. Diese Leuchtstoffmischung wird dann in einer Konzentration von 6 % w/w in einem optisch transparenten Silikon dispergiert. Das so erhaltene Silikon-Leuchtstoff-Gemisch wird mit Hilfe eines automatischen Dispensers auf den Chip einer UV-Licht emittierenden Halbleiter-LED (UV-LED mit 1 W Leistungsaufnahme und einer Emission bei 390 nm) aufgebracht und unter Wärmezufuhr ausgehärtet.

## Patentansprüche

1. Verbindung der Formel I
(A_{1-w}Eu_{w})(E_{12-z}(G₁Mg₁)_{z})O₁₉ I
worin
A ein oder mehrere divalente Elemente ausgewählt aus der Gruppe Sr, Ba und Ca,
E ein oder mehrere trivalente Elemente ausgewählt aus der Gruppe AI, Ga, In und Sc,
G ein oder mehrere tetravalente Elemente ausgewählt aus der Gruppe Si und Ge, bedeuten und
0 < z ≤ 4,
0,01 ≤ w ≤ 0,4 ist.

2. Verbindung nach Anspruch 1, **dadurch gekennzeichnet, dass** z = 1 ist.

3. Verbindung nach Anspruch 1 oder 2, **dadurch gekennzeichnet, dass** G = Si ist.

4. Verbindung nach einem oder mehreren der Ansprüche 1 bis 3, **dadurch gekennzeichnet, dass** 0,01 ≤ w ≤ 0,1 ist.

5. Verbindung nach einem oder mehreren der Ansprüche 1 bis 4, **dadurch gekennzeichnet, dass** die Verbindungen der Formel I ausgewählt sind aus den Verbindungen der Formel V-1 bis V-7
((SrₛBaᵣCaₜ)_{1-w}Eu_{w})(Al₁₀SiMg)O₁₉ V-1
((CaₜBaᵣ)_{1-w}Eu_{w}) (Al₁₀SiMg)O₁₉ V-2
((SrₛBaᵣ)_{1-w}Eu_{w}) (Al₁₀SiMg)O₁₉ V-3
((SrₛCaₜ)_{1-w}Eu_{w}) (Al₁₀SiMg)O₁₉ V-4
(Sr_{1-w}Eu_{w}) (Al₁₀SiMg)O₁₉ V-5
(Ba_{1-w}Eu_{w}) (Al₁₀SiMg)O₁₉ V-6
(Ca_{1-w}Eu_{w}) (Al₁₀SiMg)O₁₉ V-7
worin 0 < r < 1, 0 < s < 1, 0 < t < 1, mit r + s + t= 1und w die unter Formel I angegebene Bedeutung hat.

6. Verfahren zur Herstellung einer Verbindung nach einem oder mehreren der Ansprüche 1 bis 5, **dadurch gekennzeichnet, dass** Silizium- und/oder Germaniumdioxid mit mindestens einer Magnesiumverbindung, mindestens einer Aluminium-, Indium-, Scandium- oder Galliumverbindung, mindestens einer Barium-, Strontium- oder Calciumverbindung und mindestens einer Europiumverbindung vermischt wird und anschließend die Mischung thermisch behandelt wird.

7. Verfahren nach Anspruch 6, **dadurch gekennzeichnet, dass** die thermische Behandlung der Mischung 2-stufig abläuft, wobei in einem ersten Schritt bei einer Temperatur > 800°C unter Luft kalziniert wird und anschließend bei einer Temperatur > 1000°C unter reduzierenden Bedingungen kalziniert wird.

8. Leuchtstoffmischung enthaltend eine oder mehrere Verbindungen nach einem oder mehreren der Ansprüche 1 bis 5.

9. Leuchtstoffmischung nach Anspruch 8, zusätzlich enthaltend mindestens einen rot-emittierenden Konversionsleuchtstoff.

10. Leuchtstoffmischung nach Anspruch 8 oder 9, zusätzlich enthaltend mindestens einen blau-emittierenden Konversionsleuchtstoff.

11. Lichtquelle enthaltend eine Primärlichtquelle und eine Leuchtstoffmischung gemäß einem oder mehreren der Ansprüche 8 bis 10.

12. Beleuchtungseinheit, enthaltend mindestens eine Lichtquelle nach Anspruch 11.

## Claims

1. Compound of the formula I
(A_{1-w}Eu_{w})(E_{12-z}(G₁Mg₁)_{z})O₁₉ I
in which
A denotes one or more divalent elements selected from the group Sr, Ba and Ca,
E denotes one or more trivalent elements selected from the group Al, Ga, In and Sc,
G denotes one or more tetravalent elements selected from the group Si and Ge, and
0 < z ≤ 4,
0.01 ≤ w ≤ 0.4.

2. Compound according to Claim 1, **characterised in that** z = 1.

3. Compound according to Claim 1 or 2, **characterised in that** G = Si.

4. Compound according to one or more of Claims 1 to 3, **characterised in that** 0.01 ≤ w ≤ 0.1.

5. Compound according to one or more of Claims 1 to 4, **characterised in that** the compounds of the formula I are selected from the compounds of the formulae V-1 to V-7
((SrₛBaᵣCaₜ)_{1-w}Eu_{w})(Al₁₀SiMg)O₁₉ V-1
((CaₜBaᵣ)_{1-w}Eu_{w}) (Al₁₀SiMg)O₁₉ V-2
((SrₛBaᵣ)_{1-w}Eu_{w}) (Al₁₀SiMg)O₁₉ V-3
((SrₛCaₜ)_{1-w}Eu_{w}) (Al₁₀SiMg)O₁₉ V-4
(Sr_{1-w}Eu_{w}) (Al₁₀SiMg)O₁₉ V-5
(Ba_{1-w}Eu_{w}) (Al₁₀SiMg)O₁₉ V-6
(Ca_{1-w}Eu_{w}) (Al₁₀SiMg)O₁₉ V-7
in which 0 < r < 1, 0 < s < 1, 0 < t < 1, where r + s + t = 1 and w has the meaning indicated under formula I.

6. Process for the preparation of a compound according to one or more of Claims 1 to 5, **characterised in that** silicon dioxide and/or germanium dioxide is mixed with at least one magnesium compound, at least one aluminium, indium, scandium or gallium compound, at least one barium, strontium or calcium compound and at least one europium compound, and the mixture is subsequently thermally treated.

7. Process according to Claim 6, **characterised in that** the thermal treatment of the mixture is carried out in 2 steps, where, in a first step, the mixture is calcined under air at a temperature > 800°C and is subsequently calcined under reducing conditions at a temperature > 1000°C.

8. Phosphor mixture comprising one or more compounds according to one or more of Claims 1 to 5.

9. Phosphor mixture according to Claim 8, additionally comprising at least one red-emitting conversion phosphor.

10. Phosphor mixture according to Claim 8 or 9, additionally comprising at least one blue-emitting conversion phosphor.

11. Light source comprising a primary light source and a phosphor mixture according to one or more of Claims 8 to 10.

12. Lighting unit containing at least one light source according to Claim 11.

## Revendications

1. Composé de la formule I :
(A_{1-w}Eu_{w})(E_{12-z}(G₁Mg₁)_{z})O₁₉ I
dans laquelle :
A représente un ou plusieurs élément(s) divalent(s) qui est/sont sélectionné(s) parmi le groupe Sr, Ba et Ca ;
E représente un ou plusieurs élément(s) trivalent(s) qui est/sont sélectionné(s) parmi le groupe Al, Ga, In et Sc ;
G représente un ou plusieurs élément(s) tétravalent(s) qui est/ sont sélectionné(s) parmi le groupe Si et Ge ; et
0 < z ≤ 4,
0,01 ≤ w ≤ 0,4.

2. Composé selon la revendication 1, **caractérisé en ce que** z = 1.

3. Composé selon la revendication 1 ou 2, **caractérisé en ce que** G = Si.

4. Composé selon une ou plusieurs des revendications 1 à 3, **caractérisé en ce que** 0,01 ≤ w ≤ 0,1.

5. Composé selon une ou plusieurs des revendications 1 à 4, **caractérisé en ce que** les composés de la formule I sont sélectionnés parmi les composés des formules V-1 à V-7 :
((SrₛBaᵣCaₜ)_{1-w}Eu_{w})(Al₁₀SiMg)O₁₉ V-1
((CaₜBaᵣ)_{1-w}Eu_{w}) (Al₁₀SiMg)O₁₉ V-2
((SrₛBaᵣ)_{1-w}Eu_{w}) (Al₁₀SiMg)O₁₉ V-3
((SrₛCaₜ)_{1-w}Eu_{w}) (Al₁₀SiMg)O₁₉ V-4
(Sr_{1-w}Eu_{w}) (Al₁₀SiMg)O₁₉ V-5
(Ba_{1-w}Eu_{w}) (Al₁₀SiMg)O₁₉ V-6
(Ca_{1-w}Eu_{w}) (Al₁₀SiMg)O₁₉ V-7
dans lesquelles 0 < r < 1, 0 < s < 1, 0 < t < 1, oùr + s + t = 1 et w présente la signification qui a été indiquée au-dessous de la formule I.

6. Procédé pour la préparation d'un composé selon une ou plusieurs des revendications 1 à 5, **caractérisé en ce que** du dioxyde de silicium et/ou du dioxyde de germanium sont/est mélangé(s) avec au moins un composé de magnésium, au moins un composé d'aluminium, d'indium, de scandium ou de gallium, au moins un composé de baryum, de strontium ou de calcium et au moins un composé d'europium, et le mélange est subséquemment traité thermiquement..

7. Procédé selon la revendication 6, **caractérisé en ce que** le traitement thermique du mélange est mis en oeuvre selon 2 étapes, dans lequel, au niveau d'une première étape, le mélange est calciné à l'air à une température > 800°C et il est subséquemment calciné sous des conditions réduites à une température > 1000°C.

8. Mélange de phosphore comprenant un ou plusieurs composé(s) selon une ou plusieurs des revendications 1 à 5.

9. Mélange de phosphore selon la revendication 8, comprenant de façon additionnelle au moins un phosphore de conversion émetteur de rouge.

10. Mélange de phosphore selon la revendication 8 ou 9, comprenant de façon additionnelle au moins un phosphore de conversion émetteur de bleu.

11. Source de lumière comprenant une source de lumière primaire et un mélange de phosphore selon une ou plusieurs des revendications 8 à 10.

12. Unité d'éclairage contenant au moins une source de lumière selon la revendication 11.
